Europäisches Patentamt

(19) European Patent Office     (11) Publication number: **0 103 052**

Office européen des brevets     **B1**

(12)     EUROPEAN PATENT SPECIFICATION

(45) Date of publication of patent specification: **26.07.89**     (51) Int. Cl.⁴: **G 03 F 7/26**

(21) Application number: **82304491.2**

(22) Date of filing: **25.08.82**

(54) Method for forming patterned resist layer on semiconductor body.

(43) Date of publication of application:
**21.03.84 Bulletin 84/12**

(45) Publication of the grant of the patent:
**26.07.89 Bulletin 89/30**

(84) Designated Contracting States:
**DE FR GB**

(56) References cited:
**EP-A-0 030 107**
**EP-A-0 053 708**
**EP-A-0 054 412**
**EP-A-0 068 675**
**US-A-4 307 176**

**RESEARCH DISCLOSURE, no.156, April 1977,
pages 23-25, article no. 15681, Havant,
Hampshire, GB., J.F. LANGFORD et al.:
"Processing of photopolymerisable materials"**

**IBM TECHNICAL DISCLOSURE BULLETIN, vol.
24, no. 1A, June 1981, page 8, Armonk, New
York, USA, R.J. PERNES et al.: "Baking
photoresist to improve adhesion"**

(73) Proprietor: **FUJITSU LIMITED
1015, Kamikodanaka Nakahara-ku
Kawasaki-shi Kanagawa 211 (JP)**

(72) Inventor: **Kobayashi, Koichi
1502-70, Kitahassaku-cho Midori-ku
Yokohama-shi Kanagawa 226 (JP)**

(74) Representative: **Fane, Christopher Robin King
et al
HASELTINE LAKE & CO. Hazlitt House 28
Southampton Buildings Chancery Lane
London, WC2A 1AT (GB)**

## Description

This invention relates to a method for forming a patterned resist layer on a semiconductor body. The invention may be applicable to a process for the processing of negative-working resists suitable for lithography using an energy radiation or ray, especially, an electron beam, X-rays or an ion beam. Such method comprises a step of heating a layer of negative-working resist on a semiconductor body in an atmosphere which is free from any oxidizing gases, after exposure to an energy radiation and before development. It is particularly useful in the manufacture of semiconductor devices.

Electron-beam exposure system has been found to be useful in providing controlled line exposure of submicron dimensions. Such dimensions, accompanied by strict tolerances, are essential to the production of integrated circuit chips. The procedure for such production is to expose a resist layer applied to a suitable substrate or base material, usually a semiconductor, to an electron beam having a width of submicron dimensions. After the resist is developed, the substrate not protected by the resist is etched, either by a chemical solution or by a plasma beam.

As is well-known in the art, a variety of negative-working resists are useful for recording an electron beam in the electron-beam exposure devices. This is because they possess high sensitivity to an electron beam of conventional voltage and also have submicron resolution capability, thermal stability, and high resistance to etching. After electron-beam exposure, the negative resists are cross-linked in the exposure area through a formation of free radicals and become insoluble in the developer used in the subsequent developing step. During development, the unexposed area of the resists is dissolved in the developer and, therefore, a negative image or resist pattern corresponding to the pattern of the electron-beam exposure is formed on the substrate.

It has been found that in many or substantially all of the negative-working resists for electron-beam exposure, such as poly(glycidyl methacrylate) (PGMA), poly(glycidyl methacrylate-co-ethyl acrylate) (P(GMA-co-EA)), and poly(diallyl orthophthalate) (PDOP) further cross-linking occurs after the electron-beam exposure while still in the electron-beam exposure device. The additional cross-linking reaction of the negative resists after the electron beam exposure is known in the art as "post-polymerization" and is considered to be caused by the radicals remaining in the resists after completion of the electron beam exposure. The post-polymerization in the exposed area of the resists results in undesirable variation of the width and thickness of the resulting resist patterns.

The post-polymerization of the electron-beam exposed negative-working resists is particularly prone to occur in the device chips or parts of resist coated wafers, namely, semiconductor substrates. Resist coated wafers comprise a plurality of device chips. The first chip exposed is contained in the electron-beam exposure device, and therefore maintained under cross-linking conditions, until the electron-beam exposure of the last chip of the wafer is completed. The last chip exposed does not exhibit any, or in any case less, post-polymerization, because the wafer is removed from the exposure device immediately after the completion of exposure of that last chip. The post-polymerization of the resists clearly depends on the residence time in the electron-beam exposure device after electron-beam exposure, and therefore decreases from the first to last electron-beam exposure steps. Actual wafers show relatively wide and thick resist patterns formed on the first chip exposed, and relatively narrow and thin resist patterns formed on the last chip exposed. Further, the percentage residual coating increases along with the increased residence time of the exposed resists in the exposure device. The term "percentage residual coating" used herein means the percentage of the thickness of the coated resist left after electron-beam exposure and developing (residual resist coating), based on the initial thickness of the coated resists.

To solve the problem of the variation of width and thickness, it has herebefore been proposed, as disclosed in EP—A—0 054 412, to further maintain the electron-beam exposed negative resists in a curing chamber appended to the electron-beam exposure device, before developing, in order to intentionally cause a further cross-linking reaction of the exposed and thus cross-linked resists. The curing chamber must be in vacuum or filled with a non-oxidizing atmosphere such as nitrogen gas, and the irradiated resists are not heated in the curing chamber. This proposal is based on the fact that further or additional cross-linking of the resists in the curing chamber makes variations of the post-polymerization of the resists in the exposure device negligible and thus is effective for attaining a predetermined percentage residual coating.

One difficulty with the above procedure is that the curing time is relatively long, generally, about three to five times the electron-beam exposure time. This means that, to maintain the same speed of processing as without this additional step, three to five wafers must be processed in the curing chamber at once. This procedure is technically troublesome.

EP—A—0 030 107 proposes the use of negative-working resists comprising a phenol-formaldehyde novolak resin and a compound containing at least one azido radical, which do not undergo spontaneous cross-linking when left to stand under high vacuum after exposure. To promote cross-linking of these resins they are heated after exposure at temperatures of from 60 to 100°C, e.g. 70 to 80°C.

It is desirable to provide a process for the processing of negative-working resists for energy radiation exposure which ensures a high dimensional accuracy of the resulting resist patterns and a constant thickness of the resist coating remaining on the exposed area, and provides a high percentage residual coating, while still allowing curing of the exposed resists to be carried out in a relatively short time. It is also desirable to allow straight-line processing of the resists.

According to the invention, a method of forming a patterned resist layer on a semiconductor body comprises projecting a beam of X-rays, an electron beam or an ion beam to a desired region of a layer of a negative-working resist on the semiconductor body in an environment which is free from oxidising gases, said resist being such that after irradiation it undergoes cross-linking on standing under vacuum at room temperature, transferring said irradiated resist layer-bearing semiconductor body, without being exposed to an oxidising atmosphere, to a post-polymerisation chamber in which it is maintained in an environment free from oxidising gases, heating said resist layer in said post-polymerisation chamber at a temperature higher than room temperature but not exceeding 60°C so that post-polymerisation of said negative-working resist is substantially accomplished, and then developing the exposed and post-polymerised negative-working resist.

In an embodiment of this invention, the layer of negative-working resist may be heated in a vacuum.

In another preferred embodiment of this invention the environment in which the resist layer is heated after exposure and before development may be an atmosphere comprising nitrogen gas.

While this invention is described hereinafter with regard to exposure with an electron beam, it is also useful for exposure to X-rays or an ion beam.

Reference will now be made, by way of example, to the accompanying drawings, in which:

Fig. 1 is a schematic drawing of an electron-beam exposure device for carrying out a method embodying the present invention.

Fig. 2 shows a modification of the curing chamber shown in Fig. 1;

Fig. 3 shows another modification of the curing chamber shown in Fig. 1;

Fig. 4 is a graph of percentage residual coating versus exposure dose, with increase of curing time, for a prior art method;

Fig. 5 is a graph showing the temperature dependence of percentage residual coating and finally curing effects in an embodiment of this invention; and

Fig. 6 is a graph showing the relation between curing time and percentage residual coating at different curing temperatures in an embodiment of this invention.

It is desirable that the electron-beam exposed negative-working resists be heated at an elevated temperature, without exposure to air in the atmosphere, immediately after the electron-beam exposure and before development.

In an embodiment of this invention post-polymerization or cross-linking reaction of the resists caused in an electron-beam exposure step is intentionally extended through heating at a high temperature beyond room temperature. The extended cross-linked reaction of the resists is still very short, however, compared with some prior art methods.

In order to maintain the electron-beam exposed resists under air-tight conditions, it is proposed to apply a relatively weak vacuum to a curing chamber connected to the electron-beam exposure device or introduce into the curing chamber a non-oxidizing gas to reduce the oxygen concentration in the curing chamber to 1% or less. Examples of non-oxidizing gases useful in the practice of this invention include nitrogen, carbon dioxide, hydrogen, methane, rare gases such as argon and helium, and mixtures thereof. Nitrogen is particularly useful for the purpose of this invention.

As described above, the electron-beam exposed resists have to be heated in the curing chamber at a high temperature beyond room temperature (about 20 to 30°C). It has been found that heating should be made at a temperature of more than room temperature and lower than 60°C, most preferably, about 30°C to about 50°C. Higher temperatures should be avoided since they cause an undesirable thermal cross-linking of the resists, thereby resulting in decreased definition of the resist patterns. It is to be noted that the thermal cross-linking is distinguished from the cross-linking intended in the method of this invention.

Heating can be carried out by means of any conventional heating means well-known in the art. Representative heating means useful in this invention include convection heaters, microwave heaters, and infrared lamp heaters. The use of ultraviolet lamps should be avoided, since some types of negative-working resists are sensitive to ultraviolet radiation. If a non-oxidizing atmosphere is used instead of a vacuum, heating may also be carried out by circulating heated non-oxidizing gases in the curing chamber.

Embodiments of the invention can be used for many conventional negative-working resists for electron-beam exposure which are well-known in the art. The invention is preferably used for PGMA, P(GMA-co-EA), and PDOP, set-forth above, copolymers of allylmaleate (CAM), cross-linking electron resists (CER), and copolymers of maleic anhydride and fluoroalkylvinyl-ether (CMF).

It is necessary in this invention that the electron-beam exposed negative resists be maintained in vacuum or in a non-oxidizing atmosphere. If the exposed resists are exposed, before curing, to the air in the atmosphere even for a moment, it is difficult to attain the desired further cross-linking.

To better understand the invention, a process of formation of a negative resist pattern on a substrate and etching of the substrate, is described below.

First, a solution of a selected polymer useful as a negative-working resist for electron-beam exposure is prepared as a resist. Preferred solvents include 2-methoxyethyl acetate, 2-ethoxyethyl acetate, 2-ethoxyethanol, 2-butanone and mixtures of these with 2-propanol or ethanol.

The resist is then coated on a substrate by spin coating, brushing, roll coating, doctor-blade coating, or the like. Any suitable substrate may be used. Particularly preferred substrates include semiconductors such as silicon wafers. Before the coating, the substrate is preliminarily washed to improve the adhesive property of the resist thereon.

The resist is then pre-baked. This is conveniently accomplished by baking in an oven, optionally in a vacuum, for example, at 90°C for 20 minutes. This step is effective to completely remove the solvent remaining in the resist coating. After prebaking, the resist is imagewise exposed to an electron beam. The exposure procedures used are well known and no discussion concerning the electron-beam exposure devices and the operation conditions is necessary.

The resist is cured and then developed to remove the unexposed areas. The development can be carried out with same solvents as set forth above. After development, the negative image or resist pattern is finally formed on the substrate. The formed image or pattern possesses a high dimensional accuracy and a constant thickness of the resist coating remaining in the exposed areas, in addition to thermal stability and high resistance to etching.

Optionally, a post-bake step is included after the electron-beam exposure and development to enhance adhesion of the final resist coating to the areas to be protected, prior to etching.

Etching of the underlying substrate is achieved by application of a chemical solvent or plasma gas to the substrate. The etched substrate can be effectively used to produce semiconductor devices and the like after subsequent processing.

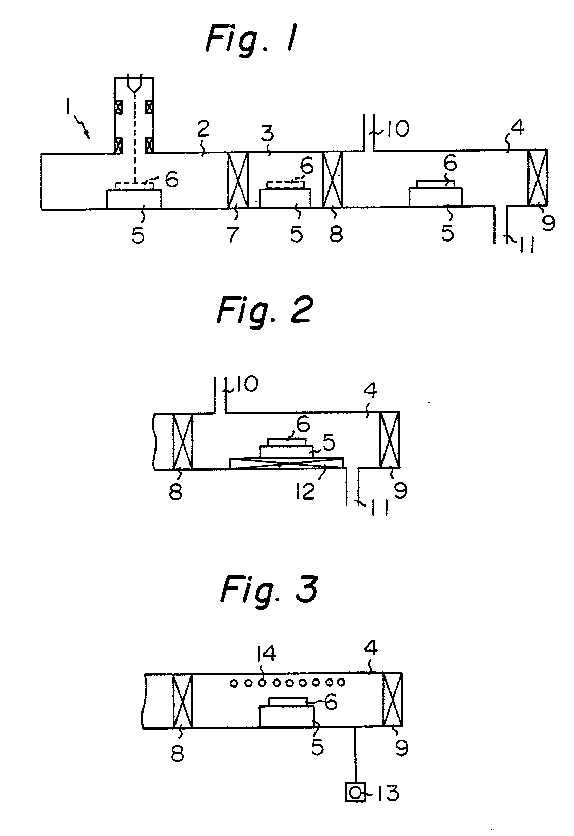

Figure 1 shows one example of an electron-beam exposure device for carrying out a process embodying the invention. Exposure device 1 comprises exposure chamber 2, intermediate chamber 3, and curing chamber 4. Gates 7 and 8 connect intermediate chamber 3 with exposure chamber 2 and curing chamber 4. Gate 9 connects curing chamber 4 with the outside. Curing chamber 4 has gas inlet 10 and gas outlet 11. Reference numerals 5 refer to a moving stage. Stage 5 carries specimen 6 thereon.

Specimen 6 is a semiconductor wafer and comprises a substrate having coated thereon a negative-working resist for electron-beam exposure. The resist coating (not shown) of specimen 6 is imagewise exposed to an electron beam, shown by the vertical dotted line, in electron-beam exposure chamber 2. After exposure, specimen 6 is conveyed on stage 5 through gate 7 to intermediate chamber 3, which has been previously controlled to a vacuum. Gate 7 immediately closes and nitrogen (or another non-oxidizing gas) is introduced to intermediate chamber 3, raising it to a certain pressure. At the same time, nitrogen gas heated to a predetermined temperature, for example, about 50°C, is being circulated from gas inlet 10 to gas outlet 11 to fill curing chamber 4 with a free flow of hot gas. Specimen 6 is conveyed from chamber 3 through gate 8 to curing chamber 4, where it undergoes curing or further cross-linking of the resists, then is removed through gate 9.

Figure 2 shows a modification of the curing chamber of Fig. 1. The modification consists of the provision of a heating means, convection heater 12, which allows unheated nitrogen gas to be introduced into curing chamber 4.

Figure 3 shows still another modification of the curing chamber of Fig. 1. The modification consists of the rotor 13 used to control the pressure of the curing chamber to a moderate vacuum. Thus, unlike the chambers of Figs. 1 and 2, no gas is introduced therein and, therefore, no gas inlets or outlets are necessary. For heating, infrared lamps 14 are used. Since curing chamber 4 is maintained under vacuum conditions, no gas need either be introduced into the adjacent intermediate chamber in the previous step.

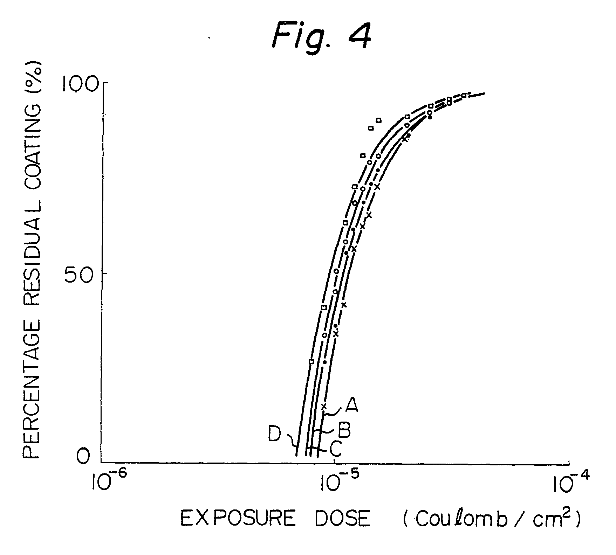

Figure 4 is a graph of the prior art and shows the curing time and exposure dose dependence of percentage residual coating and finally curing effects. The exposure dose is given on a logarithmic scale.

In order to ascertain the above dependence, the negative resist PDOP ($M_w$=about 10,000) was coated on the silicon substrate in the thickness of 1.70 μm, pre-baked at 90°C for 20 minutes, exposed to an electron beam at different exposure doses, and cured in a nitrogen atmosphere at 23.5°C for different curing times, namely, 0 min. (Curve A), 3 min. (Curve B), 10 min. (Curve C), and 30 min. (Curve D). As the graph shows, percentage residual coating was increased with increase of exposure dose and with increase of curing time.

The curing time of the first chip exposed is naturally different from that of the last chip exposed. This fact means that different curing times of the exposed chip of the wafer cause a variation of the percentage residual coating as well as a variation of the width and thickness of the resulting resist patterns. However, as is clear from Fig. 4, difference of the percentage residual coating between the first chip and the last chip can be minimized with the extension of the curing time. This is the reason why the prior method needs very long curing time, generally, about three to five times the exposure time.

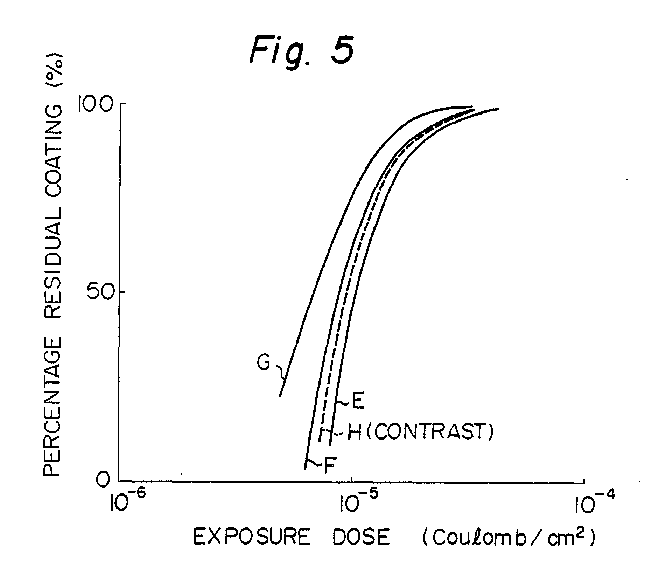

Fig. 5 is a graph showing the curing time dependence of percentage residual coating and finally curing effects in an embodiment of the invention. The exposure dose is given on a logarithmic scale, as in Fig. 4.

In order to ascertain the above dependence, the procedure of Fig. 4 was repeated except that curing was made at different temperatures (23.5°C, 30°C and 60°C) for ten (10) minutes. Curve E shows a resist cured at 23.5°C for 10 minutes, curve F at 30°C for 10 minutes, and curve G at 60°C for 10 minutes. As the graph shows, percentage residual coating was increased with increase of curing temperature.

Further, dotted curve H is a contrast and shows a resist cured at 23.5°C for 30 minutes. Comparison of this curve with the other curves E, F and G indicates that heating of the exposed negative resist in the curing chamber, in accordance with the present invention, can be more effective than the extension of the curing time in view of achieving an enhanced percentage residual coating.

Furthermore, similar results were obtained when moderate vacuum was applied to the curing chamber in place of a nitrogen atmosphere.

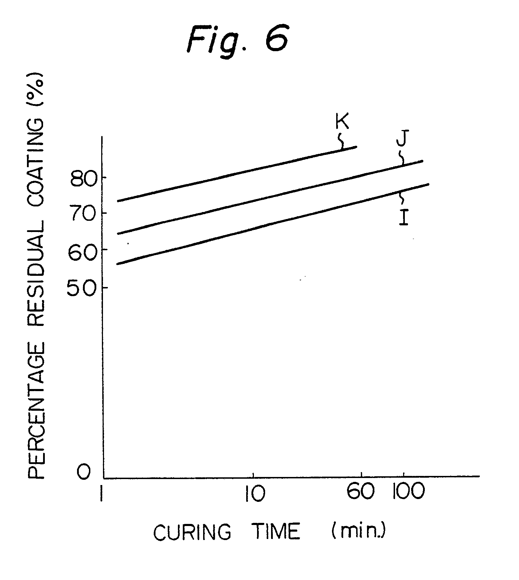

The curing effects of the method described may be seen from the graph of Fig. 6 in which the relation between curing time and percentage residual coating at different curing temperatures is shown. The graph indicates the results of curing with PDOP ($M_w$=about 10,000) exposed to an electron beam at an exposure dose of about $1.2 \times 10^{-5}$ C/cm². Lines I, J and K indicate the case of a curing temperature of about 23.5°C, 30°C and 60°C, respectively. The curing time is given on an logarithmic scale.

As apparent, the percentage residual coating increased along with the increased time after exposure, namely, the curing time. Further, the percentage residual coating per unit time increase with elevation of the temperature of the specimen in the curing chamber, namely, the curing temperature. For example, a curing time of only about 10 minutes is needed to attain a percentage residual coating of 72% at a curing temperature of about 30°C, while a curing time of about 60 minutes is needed at a curing temperature of 23.5°C. It is believed that since post-polymerization of the resist is a kind of chemical reaction, a higher temperature increases the polymerization velocity. A higher curing temperature therefore accelerates the post-polymerization effect of the resist.

As can be understood from the above description, the reaction velocity of the post-polymerization is accelerated with elevation of the temperature. Therefore, if the curing temperature is elevated, the curing time can be shortened. Thus, with the method embodying the present invention a curing time equal to or less than the exposure time is possible, while a prior method can need a curing time which is 3 to 5 times the exposure time, in order to minimize differences in the percentage residual coating and pattern size of the resulting resist patterns.

Further, the method described is applicable not only to electron beam exposure, but also to X-ray exposure in which exposure is carried out by means of a step-and-repeat system in a non-oxidizing atmosphere (including vacuum), and ion beam exposure.

## Claims

1. A method of forming a patterned resist layer on a semiconductor body, wherein a beam of X-rays, an electron beam or an ion beam is projected to a desired region of a layer of negative-working resist on the semiconductor body in an environment which is free from oxidising gases, said resist being such that after irradiation it undergoes cross-linking on standing under vacuum at room temperature, and said irradiated resist layer-bearing semiconductor body is transferred, without being exposed to an oxidising atmosphere, to a post-polymerisation chamber in which it is maintained in an environment free from oxidising gases so that post-polymerisation of said negative-working resist is substantially accomplished, and the exposed and post-polymerised negative-working resist is then developed, characterised in that in the post-polymerisation chamber the resist layer is heated at a temperature higher than room temperature but not exceeding 60°C.

2. A method according to claim 1 wherein the semiconductor body is a semiconductor wafer, and chip patterns are successively exposed on said wafer.

3. A method according to claim 1 or claim 2 wherein said environment is a vacuum.

4. A method according to claim 1 or claim 2 wherein said environment is an atmosphere comprising nitrogen gas.

5. A method according to any preceding claim wherein said layer of negative-working resist is heated at a temperature of about 30°C to about 50°C.

## Patentansprüche

1. Verfahren zur Bildung einer gemusterten Resistschicht auf einem Halbleiterkörper, bei welchem ein Röntgenstrahl, ein Elektronenstrahl oder ein Ionenstrahl auf einen gewünschten Bereich einer Schicht eines negativ arbeitenden Resists auf dem Halbleiterkörper in einer Umgebung projiziert wird, die frei von oxidierenden Gases ist, wobei das genannte Resist derart ist, daß es nach seiner Bestrahlung einer Vernetzung unterliegt, während es bei Raumtemperatur unter Vakuum steht, und der Halbleiterkörper, der die bestrahlte Resistschicht trägt, ohne einer oxidierenden Atmosphäre ausgesetzt zu werden, zu einer Nachpolymerisationskammer transferiert wird, in welcher er in einer Umgebung gehalten wird, die frei von oxidierenden Gasen ist, so daß NachPolymerisation des genannten negativ arbeitenden Resists im wesentlichen vollendet wird, und das exponierte und nachpolymerisierte, negativ arbeitende Resist dann entwickelt wird, dadurch gekennzeichnet, daß die Resistschicht in der Nachpolymerisationskammer auf eine Temperatur oberhalb Raumtemperatur, jedoch nicht über 60°C erhitzt wird.

2. Verfahren nach Anspruch 1, bei dem der Halbleiterkörper ein Halbleiterwafer ist, und Chipmuster sukzessiv auf dem genannten Wafer exponiert werden.

3. Verfahren nach Anspruch 1 oder 2, bei dem die genannte Umgebung ein Vakuum ist.

4. Verfahren nach Anspruch 1 oder 2, bei dem die genannte Umgebung einer Atmosphäre ist, die Stickstoffgas enthält.

5. Verfahren nach einem der vorhergehenden Ansprüche, bei der die genannte Schicht von negative arbeitendem Resist auf eine Temperatur von etwa 30°C bis etwa 50°C erhitzt wird.

**Revendications**

1. Procédé de formation d'une couche configurée d'agent sensible de type réserve sur un corps semiconducteur, où on projette un faisceau de rayons X, un faisceau électronique ou un faisceau ionique sur une région voulue d'une couche d'agent sensible négatif se trouvant sur le corps semiconducteur dans un environnement qui est exempt de gaz oxydants, ledit agent sensible étant tel que, après l'irradiation, il subit une réticulation en restant sous vide à la température ambiante, et on transfère ledit corps, semiconducteur portant la couche d'agent sensible irradié, sans l'exposer à une atmosphère oxydante, jusque dans une chambre de post-polymérisation dans laquelle il est maintenu dans un environnement exempt de gaz oxydants de sorte qu'une post-polymérisation dudit agent sensible négatif est sensiblement réalisée, puis on développe l'agent sensible négatif exposé et post-polymérisé, caractérisé en ce que, dans la chambre de post-polymérisation, on chauffe la couche d'agent sensible à une température supérieure à la température ambiante, mais ne dépassant pas 60°C.

2. Procédé selon la revendication 1, où le corps semiconductor est une pastille semiconductrice, et des configurations de puces sont successivement exposées sur ladite pastille.

3. Procédé selon la revendication 1 ou 2, où ledit environnement est le vide.

4. Procédé selon la revendication 1 ou 2, où ledit environnement est une atmosphère contenant de l'azote gazeux.

5. Procédé selon l'une quelconque des revendications précédentes, où un chauffe ladite couche d'agent sensible négatif à une température d'environ 30°C à environ 50°C.

EP 0 103 052 B1

Fig. 1

Fig. 2

Fig. 3

1

Fig. 4

PERCENTAGE RESIDUAL COATING (%)

100

50

0

A

B

C

D

$10^{-6}$          $10^{-5}$          $10^{-4}$

EXPOSURE DOSE   ( Coulomb / cm$^2$ )

Fig. 5

# Fig. 6